# EUROPÄISCHE PATENTSCHRIFT

(11) **EP 0 766 394 B1**
(45) Veröffentlichungstag und Bekanntmachung des Hinweises auf die Patenterteilung: **20.03.2002**
(21) Anmeldenummer: 96113013.5
(22) Anmeldetag: 13.08.1996
(51) Int. Cl.: H03K 17/0412

(54) **Schaltungsanordnung zum Ansteuern eines Leistungs-Enhancement-MOSFET**
Circuit arrangement for controlling a power enhancement MOSFET
Montage servant à commander un transistor à effet de champ MOS de puissance à enrichissement

(30) Priorität: 27.09.1995 DE 19535987
(43) Veröffentlichungstag der Anmeldung: 02.04.1997
(73) Patentinhaber: Infineon Technologies AG, 81669 München (DE)
(72) Erfinder: Jenö, Tihanyi, Dr. Ing., 85551 Kirchheim (DE)
(74) Vertreter: Bickel, Michael

(56) Entgegenhaltungen:
- EP-A- 0 236 967
- EP-A- 0 294 887
- EP-A- 0 572 706

## Beschreibung

Die Erfindung betrifft eine Schaltungsanordnung zum Ansteuern eines Leistungs-Enhancement-MOSFET mit sourceseitiger Last und mit den Merkmalen:
a) Der Drainanschluß des Leistungs-MOSFET ist mit einer Klemme zum Anlegen einer Versorgungsspannung verbunden,
b) der Gateanschluß des Leistungs-MOSFET ist über eine Gleichrichteranordnung und einen Kondensator mit einer ersten Steuereingangsklemme zum Anlegen eines Wechselspannungssignales in Verbindung,
c) die Gate-Sourcekapazität des Leistungs-MOSFET ist über einen zweiten MOSFET entladbar,
d) der Sourceanschluß und der Drainanschluß des Leistungs-MOSFET sind über eine Reihenschaltung eines ersten Widerstandes und der Laststrecke eines dritten MOSFET, der ein Enhancement-MOSFET und vom entgegengesetzten Kanaltyp ist, verbunden,
e) eine erste Stromquelle ist über einen ersten steuerbaren Schalter und einen zweiten Widerstand an die Klemme für Versorgungsspannung geschaltet,
f) der Verbindungspunkt zwischen ersten steuerbarem Schalter und zweiten Widerstand ist mit dem Gateanschluß des dritten MOSFET in Verbindung.

Eine solche Schaltungsanordnung ist beispielsweise in EP 0 236 967 B1 beschrieben. Diese Schaltungsanordnung arbeitet nach dem Prinzip der bekannten Spannungsverdopplerschaltung. Mit einer solchen Schaltung ist es möglich, einen MOSFET, insbesondere einen Leistungs-MOSFET, mit sourceseitiger Last auch dann voll leitend zu steuern, wenn das Potential am Gateanschluß kleiner als das Potential am Drainanschluß ist. Bei der beschriebenen Schaltungsanordnung sind insgesamt drei Steuersignale zum Ansteuern des MOSFET notwendig. Um den MOSFET einzuschalten, muß an den zweiten Anschluß des Kondensators für die Dauer des gewollten Einschaltens ein Wechselspannungssignal angelegt werden und für die gleiche Zeitspanne an den übrigen beiden Eingangsklemmen jeweils ein Schaltsignal entgegengesetzter Polarität anliegen. Das nach Ablauf der Einschaltdauer an eine der drei Klemmen anzulegende positive Steuersignal dient dazu, einen mit seiner Laststrecke zwischen den Gateanschluß des MOSFET und Bezugspotential liegenden Transistor einzuschalten, um hierdurch für eine schnelle Entladung der Gate-Sourcekapazität des MOSFET zu sorgen, so daß der MOSFET schnell ausschalten kann.

Die Notwendigkeit von drei Steuersignalen zum Einschalten des MOSFET ist umständlich. Problematisch ist auch, daß die Ansteuerschaltung zum Einschalten des MOSFET mit dem Massepotential der Last zu verbinden ist.

Eine andere Ansteuerschaltung für einen MOSFET ist aus EP 0 572 706 A1 bekannt. Die dort beschriebene Schaltungsanordnung weist ebenfalls eine an den Gateanschluß des Leistungs-MOSFET geschaltete Reihenschaltung eines Kondensators mit Gleichrichteranordnung auf. Zur Beschleunigung des Abschaltvorganges ist parallel zur Gate-Sourcestrecke des Leistungs-MOSFET ein Depletion-MOSFET geschaltet, welcher beim Anlegen eines geeigneten Steuersignales an seinem Gateanschluß eingeschaltet wird. Bei dieser Schaltungsanordnung sind die Spannungen der Ladungspumpe auf die Betriebsspannung bezogen. Die Schaltung ist damit auch funktionsfähig, wenn das Massepotential der Ansteuerlogik von dem Last-Massepotential abweicht. Problematisch bei dieser Schaltungsanordnung ist, daß neben dem an den Kondensator anzulegenden Wechselspannungsignal am Eingang der Ladungspumpe ein weiteres, separates Steuersignal zur Ansteuerung des Depletion-MOSFET vorgesehen werden muß.

Bei diesen bekannten Schaltungsanordnungen ist der Leistungs-MOSFET jeweils ein Enhancement-MOSFET, dessen Gate-Sourcekapazität zum beschleunigten Abschalten über einen parallel zur Gate-Sourcestrecke liegenden Depletion-MOSFET entladen wird. Die unterschliedlichen MOSFET-Typen erfordern eine aufwendige Herstellungstechnologie, da der Depletion-MOSFET sowohl einer zusätzlichen Maske als auch eines zusätzlichen Oxidations-und Implantationschrittes bei der Ausführung der Schaltungsanordnung innerhalb eines Halbleiterkörpers bedarf.

Der vorliegenden Erfindung liegt die Aufgabe zugrunde, eine Schaltungsanordnung zum Ansteuern eines Leistungs-MOSFET anzugeben, die den ausschließlichen Einsatz von Enhancement-FETs erlaubt und damit einfacher herzustellen ist.

Diese Aufgabe wird bei der eingangs genannten Schaltungsanordnung durch folgende zusätzliche Merkmale gelöst:
g) der zweite MOSFET (10) ist ein Enhancement-MOSFET vom gleichen Kanaltyp wie der Leistungs-MOSFET (1),
h) der Gateanschluß (G) des zweiten MOSFET (10) ist an den Verbindungspunkt von drittem MOSFET (11) und ersten Widerstand (13) angeschlossen,
i) eine zweite Stromquelle (18) ist über einen zweiten steuerbaren Schalter (16) und einen dritten Widerstand (15) an die Klemme (2) für Versorgungsspannung (V_{D}) geschaltet,
j) eine Diode (20) ist mit dem Katodenanschluß (K) an den Verbindungspunkt von dritten Widerstand (15) und zweiten steuerbaren Schalter (16) und mit dem Anodenanschluß (A) an den Sourceanschluß (S) des zweiten MOSFET (10) geschaltet.
k) zum Einschalten des Leistungs-MOSFET (1) sind die beiden steuerbaren Schalter (16, 17) offen und zum Ausschalten geschlossen.

Weiterbildungen der Erfindung sind Gegenstand der Unteransprüche.

Die Erfindung wird anhand von zwei Ausführungsbeispielen in Verbindung mit zwei Figuren näher erläutert.

Es zeigen:
- Figur 1: Ein erstes Ausführungsbeispiel einer Schaltungs-einer Schaltungsanordnung nach der Erfindung,
- Figur 2: ein zweites Ausführungsbeispiel einer Schaltungsanordnung nach der Erfindung mit Überstrom- und Überspannungsschutz.

In den nachfolgenden Figuren bezeichnen, sofern nicht anders angegeben, gleiche Bezugszeichen gleiche Teile mit gleicher Bedeutung.

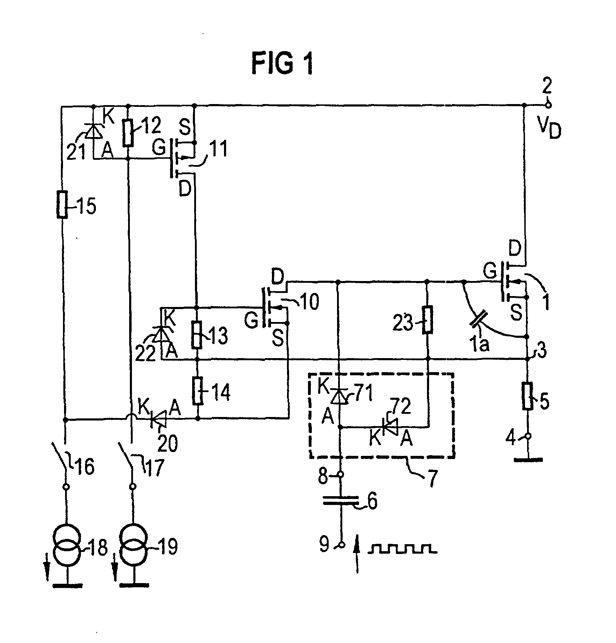

Die Schaltungsanordnung nach Figur 1 enthält einen Leistungs-MOSFET 1, hier einen Enhancement-MOSFET vom n-Kanaltyp, dessen Drainanschluß D mit einer Klemme 2 und dessen Sourceanschluß S mit einer Klemme 3 in Verbindung steht. Die Klemme 2 ist zum Anlegen einer Versorgungsspannung V_{D} vorgesehen. Zwischen der Klemme 3 und einer Klemme 4, die auf Bezugspotential bzw. Massepotential liegt, ist eine Last 5 geschaltet, die vom Leistungs-MOSFET 1 an die Klemme 2 und damit Versorgungsspannung V_{D} schaltbar ist. Die Last 5 kann beispielsweise eine Lampe, ein Motor, ein Ventil oder dergleichen sein. Der Gateanschluß G des Leistungs-MOSFET 1 ist über eine erste Gleichrichteranordnung 7 an einen ersten Anschluß 8 eines Kondensators 6 geschaltet. Dieser Kondensator 6 ist Bestandteil einer Ladungspumpenschaltung, um das Gatepotential am Gateanschluß G des Leistungs-MOSFET 1 zum Einschalten des Leistungs-MOSFET nach Maßgabe von Steuersignalen einer nicht gezeigten Ansteuerschaltung auf so hohe Werte anzuheben, daß der Leistungs-MOSFET 1 sicher einschaltet und eingeschaltet bleibt, solange ein entsprechendes Steuersignal an der Ansteuerschaltung anliegt.

Die Ansteuerschaltung stellt zum Einschalten des Leistungs-MOSFET 1 am zweiten Anschluß 9 des Kondensators 6 ein Wechselspannungssignal, insbesondere ein Rechtecksignal, zur Verfügung. Dieses Wechselspannungssignal kann beispielsweise eine getaktete Gleichspannung sein, deren Hub der Versorgungsspannung V_{D} entspricht.

Damit beim Anlegen eines Wechselspannungsignales am zweiten Anschluß 9 des Kondensators 6 tatsächlich ein ausreichend positives Gatepotential am Gateanschluß G des Leistungs-MOSFET 1 anliegt, ist die Gleichrichteranordnung 7 in geeigneter Weise gepolt. Im Ausführungsbeispiel von Figur 1 weist die Gleichrichteranordnung 7 eine erste Diode 71 auf, die mit ihrem Katodenanschluß K an den Gateanschluß G des Leistungs-MOSFET 1 und mit ihrem Anodenanschluß A an den ersten Anschluß 8 des Kondensators 6 geschaltet ist. Des weiteren verfügt die Gleichrichteranordnung 7 über eine zweite Diode 72, deren Katodenanschluß K an den Anschluß 8 des Kondensators 6 geschaltet ist. Der Anodenanschluß A dieser zweiten Diode 72 ist an die Klemme 3 und damit den Sourceanschluß S des Leistungs-MOSFET 1 geschaltet. Die Durchlaßrichtung dieser ersten Gleichrichteranordnung 7 ist folglich so gewählt, daß am Gateanschluß G des Leistungs-MOSFET 1 immer ein positives Potential ansteht, sofern am zweiten Anschluß 9 des Kondensators 6 ein Wechselspannungssignal angelegt ist und der noch zu erläuternde, zur Entladung der Gate-Sourcekapazität vorgesehene zweite Enhancement-MOSFET 10 ausgeschaltet ist.

Soll die Last 5 von der Versorgungsspannung V_{D} abgeklemmt werden, ist der Leistungs-MOSFET 1 auszuschalten. Damit dies möglichst schnell erfolgt, muß die Gate-Sourcekapazität 1a, die in Figur 1 eingezeichnet ist, des Leistungs-MOSFET 1 möglichst schnell entladen werden. Hierfür dienen der mit seiner Laststrecke parallel zur Gate-Sourcekapazität 10 geschaltete zweite MOSFET 10 sowie weitere Schaltungskomponenten, welche nachfolgend, unter Bezugnahme auf Figur 1 erläutert werden.

Der zweite MOSFET 10 ist mit seinem Drainanschluß D an den Gateanschluß G des Leistungs-MOSFET 1 geschaltet. Der Sourceanschluß S dieses zweiten MOSFET 10 ist an einen Anschluß eines Widerstandes 14 geschaltet, dessen anderer Anschluß mit der Klemme 3 in Verbindung steht. Zwischen die Klemme 2 und die Klemme 3 ist die Serienschaltung einer Laststrecke eines dritten Enhancement-MOSFET 11 mit einem weiteren Widerstand 13 geschaltet. Der Sourceanschluß S des dritten MOSFET 11 ist mit der Klemme 2 in Verbindung und der Widerstand 13 ist mit einem Anschluß an die Klemme 3 geschaltet. Der Gateanschluß G des MOSFET 10 ist mit dem Drainanschluß D des MOSFET 11 verbunden.

Des weiteren sind zwei Stromquellen 18, 19 jeweils mit einem Anschluß an die Klemme 4 für Bezugspotential geschaltet. Die jeweils anderen freien Anschlüsse dieser Stromquellen 18, 19 sind je über einen steuerbaren Schalter 16, 17 mit einem Widerstand 15, 12 verbunden. Die freien Anschlüsse dieser Widerstände 15, 12 sind an die Klemme 2, an der die Versorgungsspannung V_{D} anzulegen ist, in Kontakt. Der Verbindungspunkt von Widerstand 14 und Sourceanschluß S des zweiten MOSFET 10 ist an den Anodenanschluß A der Diode 20 angeschlossen. Der Katodenanschluß K dieser Diode 20 steht mit dem Verbindungspunkt des Widerstandes 15 und des steuerbaren Schalters 16 in Kontakt.

Den Widerständen 12 und 13 können Zenerdioden 21, 22 parallel geschaltet werden. Die Zenerdiode 21, die mit ihrem Katodenanschluß K an die Klemme 2 gelegt ist, schützt die Gate-Sourcekapazität des dritten MOSFET 11 gegen Überspannung. Durch die Zenerdiode 22, deren Katodenanschluß K mit dem Verbindungspunkt des Widerstandes 13 und dem Drainanschluß D des dritten MOSFET 11 und damit auch dem Gateanschluß G des zweiten MOSFET 10 verbunden ist, wird verhindert daß der zweite MOSFET 10 übersteuert wird.

Die in Fig. 1 dargestellten MOSFET 1, 10 und 11 sind jeweils vom Enhancement-Typ. Der Leistungs-MOSFET 1 und der zweite MOSFET 10 sind darüber hinaus vom n-Kanaltyp, während der dritte MOSFET 11 vom p-Kanaltyp ist.

Die Wirkungsweise der in Fig. 1 dargestellten Schaltungsanordnung stellt sich folgendermaßen dar.

Zunächst wird davon ausgegangen, daß die steuerbaren Schalter 16, 17, die durch p- oder n-Kanal-MOSFETS realisiert werden können, offen sind. Es ist hier anzumerken, daß die beiden steuerbaren Schalter 16, 17 zweckmäßigerweise gleichzeitig offen oder geschlossen sind. Am Anschluß 9 des Kondensators 6 steht vereinbarungsgemäß ein Wechselspannungssignal an. Dieses Wechselspannungssignal führt zu einem am Gateanschluß G des Leistungs-MOSFET 1 ausreichend hohem positivem Potential, so daß der Leistungs-MOSFET 1 einschaltet und eingeschaltet bleibt, solange das Wechselspannungssignal am Anschluß 9 des Kondensators 6 ansteht und die steuerbaren Schalter 16, 17 offen sind. Es wird angenommen, daß die Versorgungsspannung V_{D} an der Klemme 2 +15 Volt beträgt. Am Gateanschluß G des Leistungs-MOSFET 1 liegen beispielsweise +20 Volt an. Der zweite MOSFET 10 und dritte MOSFET 11 ist jeweils ausgeschaltet, so daß die Gate-Sourcekapazitätät 1 (a) des Leistungs-MOSFET 1 aufgeladen bleibt.

Zum Öffnen und damit Ausschalten des Leistungs-MOSFET 1 werden die beiden steuerbaren Schalter 16 und 17 vorzugsweise gleichzeitig geschlossen. Durch das Schließen des steuerbaren Schalters 17 wird das Potential am Sourceanschluß S des zweiten MOSFET 10 gegenüber dessen Gatepotential so weit vermindert, daß der zweite MOSFET 10 einschaltet. Sobald dieser zweite MOSFET 10 einschaltet, wird die Gate-Sourcekapazität 1a des Leistungs-MOSFET 1 entladen und der Leistungs-MOSFET 1 schaltet ab. Durch das Einschalten des steuerbaren Schalters wird zugleich das Gatepotential am dritten MOSFET 11 ausreichend groß, um diesen dritten MOSFET 11 einzuschalten. Hierdurch gelangt, abgesehen bis auf den Spannungsabfall an der Laststrecke des dritten MOSFET 11, nahezu das Potential der Versorgungsspannung V_{D} an den Gateanschluß G des zweiten MOSFET 10. Das Gatepotential an diesem zweiten MOSFET 10 ist nahezu bis auf die Versorgungsspannung V_{D} angehoben, wodurch der zweite MOSFET 10 sicher eingeschaltet bleibt.

Zum Ein- und Ausschalten des Leistungs-MOSFET 1 braucht das am Anschluß 9 des Kondensators 6 anstehende Wechselspannungssignal nicht unbedingt abgeschaltet zu werden, da bei eingeschaltetem Zustand des zweiten MOSFET 10 dieses Wechselspannungssignal nicht mehr zum Aufladen der Gate-Sourcekapazität 1a des Leistungs-MOSFET 1 führen kann.

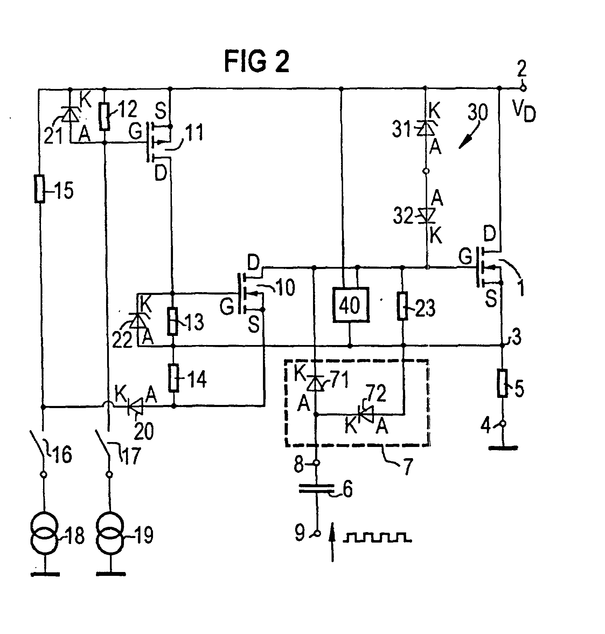

In Fig. 2 ist eine im Vergleich zur Schaltungsanordnung von Fig. 1 verbesserte Schaltungsanordnung gezeigt. Zum Schutz vor Überspannungen und insbesondere Überspannungsspitzen ist zwischen dem Drainanschluß D und dem Gateanschluß G des Leistungs-MOSFET 1 eine Diodeneinrichtung 30 geschaltet. Diese Diodeneinrichtung 30 weist eine Zenerdiode 31 mit in Reihe geschalteter Diode 32 auf. Der Katodenanschluß K der Zenerdiode 31 ist mit der Klemme 2 und der Katodenanschluß K der Diode 32 mit dem Gateanschluß G des Leistungs-MOSFET 1 in Verbindung. Die Anodenanschlüsse A der beiden Dioden 31, 32 sind miteinander in Verbindung. Zusätzlich weist die Schaltungsanordnung eine als solche bekannte Strombegrenzungseinrichtung 40 auf. Diese Strombegrenzungseinrichtung 40 verfügt über drei Anschlüsse, die mit dem Gateanschluß G, dem Drainanschluß D und dem Sourceanschluß S des Leistungs-MOSFET 1 in Verbindung sind.

Die Strombegrenzungseinrichtung 40 kann beispielsweise ein parallel zur Laststrecke des Leistungs-MOSFET 1 geschalteter IGBT mit in Reihe geschaltetem Widerstand sein, bei welchen der Verbindungspunkt einen Schalttransistor steuert, der mit seiner Laststrecke zwischen den Gateanschluß G und Sourceanschluß S des Leistungs-MOSFET 1 geschaltet ist.

Die in den Fig. 1 und 2 vorgestellten Schaltungsanordnungen können in einfacher Weise in einen Halbleiterkörper integriert werden. Die dargestellten Dioden 20, 21, 22, 31, 32, 71 und 72 können beispielsweise MOS-Dioden sein. Die Stromquellen 18, 19 können Widerstände, die durch MOSFET realisiert sind, sein.

## Patentansprüche

1. Schaltungsanordnung zum Ansteuern eines Leistungs-Enhancement-MOSFET (1) mit sourceseitiger Last (5) und mit den Merkmalen:
a) Der Drainanschluß (D) des Leistungs-MOSFET (1) ist mit einer Klemme (2) zum Anlegen einer Versorgungsspannung (V_{D}) verbunden,
b) der Gateanschluß (G) des Leistungs-MOSFET (1) ist über eine Gleichrichteranordnung (7) und einen Kondensator (6) mit einer ersten Steuereingangsklemme (9) zum Anlegen eines Wechselspannungssignales in Verbindung,
c) die Gate-Sourcekapazität des Leistungs-MOSFET (1) ist über einen zweiten MOSFET (10) entladbar,
d) der Sourceanschluß (S) und der Drainanschluß (D) de Leistungs-MOSFET (1) sind über eine Reihenschaltung eines ersten Widerstandes (13) und der Laststrecke eines dritten MOSFET (11), der ein Enhancement-MOSFET und vom entgegengesetzten Kanaltyp ist, verbunden,
e) eine erste Stromquelle (17) ist über einen ersten steuerbaren Schalter (17) und einen zweiten Widerstand (12) an die Klemme (2) für Versorgungsspannung (V_{D}) geschaltet,
f) der Verbindungspunkt zwischen erstem steuerbaren Schalter (17) und zweiten Widerstand (12) ist mit dem Gateanschluß (G) des dritten MOSFET (11) in Verbindung,
**gekennzeichnet durch** die Merkmale:
g) der zweite MOSFET (10) ist ein Enhancement-MOSFET vom gleichen Kanaltyp wie der Leistungs-MOSFET (1),
h) der Gateanschluß (G) des zweiten MOSFET (10) ist an den Verbindungspunkt von drittem MOSFET (11) und ersten Widerstand (13) angeschlossen,
i) eine zweite Stromquelle (18) ist über einen zweiten steuerbaren Schalter (16) und einen dritten Widerstand (15) an die Klemme (2) für Versorgungsspannung (V_{D}) geschaltet,
j) eine Diode (20), ist mit dem Katodenanschluß (K) an den Verbindungspunkt von dritten Widerstand (15) und zweiten steuerbaren Schalter (16) und mit dem Anodenanschluß (A) an den Sourceanschluß (S) des zweiten MOSFET (10) geschaltet.
k) zum Einschalten des Leistungs-MOSFET (1) sind die beiden steuerbaren Schalter (16, 17) offen und zum Ausschalten geschlossen.

2. Schaltungsanordnung nach Anspruch 1,
**dadurch gekennzeichnet, daß** parallel zum ersten Widerstand (13) eine erste Zenerdiode (22) geschaltet ist.

3. Schaltungsanordnung nach Anspruch 1 oder 2,
**dadurch gekennzeichnet, daß** parallel zum zweiten Widerstand (12) eine zweite Zenerdiode (21) geschaltet ist.

4. Schaltungsanordnung nach einem der Ansprüche 1 bis 3,
**dadurch gekennzeichnet, daß** die beiden steuerbaren Schalter (16, 17) gleichzeitig ein- und ausschaltbar sind.

5. Schaltungsanordnung nach einem der Ansprüche 1 bis 4,
**dadurch gekennzeichnet, daß** die erste und die zweite Stromquelle (16, 17) als Widerstand ausgebildet ist.

6. Schaltungsanordnung nach einem der Ansprüche 1 bis 5,
**dadurch gekennzeichnet, daß** zwischen den Drainanschluß (D)und Gateanschluß (G) des Leistungs-MOSFET (1) eine Diodeneinrichtung (30) geschaltet ist.

7. Schaltungsanordnung nach Anspruch 6,
**dadurch gekennzeichnet, daß** die Diodeneinrichtung (30) die Reihenschaltung einer dritten Zenerdiode (31) und einer zweiten Diode (32) aufweist, daß die dritte Zenerdiode mit ihrem Katodenanschluß (K) an die Klemme (2) für Versorgungsspannung (V_{D}) und die zweite Diode (32) mit ihrem Katodenanschluß (K) an den Gateanschluß (G) des Leistungs-MOSFET (1) geschaltet ist.

8. Schaltungsanordnung nach einem der Ansprüche 1 bis 7,
**dadurch gekennzeichnet, daß** die steuerbaren Schalter (16, 17) als p- oder n-Kanal-MOSFETS realisiert sind.

9. Schaltungsanordnung nach einem der Ansprüche 1 bis 8,
**dadurch gekennzeichnet, daß** eine Strombegrenzungsanordnung (40) zum Abschalten des Leistungs-MOSFET (1) bei Überstrom vorgesehen ist.

## Claims

1. A circuit arrangement for controlling a power enhancement MOSFET (1) with a load (5) on the source side and with the features:
a) the drain connection (D) of the power MOSFET (1) is connected to a terminal (2) for the application of a supply voltage (V_{D}),
b) the gate connection (G) of the power MOSFET (1) communicates via a rectifier arrangement (7) and a capacitor (6) with a first control input terminal (9) for the application of an alternating voltage signal,
c) the gate-source capacitance of the power MOSFET (1) can be discharged via a second MOSFET,
d) the source connection (S) and the drain connection (D) of the power MOSFET (1) are connected via a series circuit of a first resistor (13) and of the load path of a third MOSFET (11), which is an enhancement MOSFET and of the opposite channel type,
e) a first current source (17) is switched via a first controllable switch (17) and a second resistor (12) to the terminal (2) for supply voltage (V_{D}) ,
f) the connection point between the first controllable switch (17) and the second resistor (12) communicates with the gate connection (G) of the third MOSFET (11),
**characterised by** the features:
g) the second MOSFET (10) is an enhancement MOSFET of the same channel type as the power MOSFET (1),
h) the gate connection (G) of the second MOSFET (10) is connected to the connection point of the third MOSFET (11) and first resistor (13),
i) a second current source (18) is switched via a second controllable switch (16) and a third resistor (15) to the terminal (2) for supply voltage (V_{D}),
j) a diode (20) is switched by the cathode connection (K) to the connection point of the third resistor (15) and second controllable switch (16) and by the anode connection (A) to the source connection (S) of the second MOSFET (10).
k) for the connection of the power MOSFET (1) the two controllable switches (16, 17) are open and for disconnection they are closed.

2. A circuit arrangement according to Claim 1,
**characterised in that** a first Zener diode (22) is switched parallel to the first resistor (13).

3. A circuit arrangement according to Claim 1 or 2,
**characterised in that** a second Zener diode (21) is switched parallel to the second resistor (12).

4. A circuit arrangement according to one of Claims 1 to 3,
**characterised in that** the two controllable switches (16, 17) can be simultaneously connected and disconnected.

5. A circuit arrangement according to one of Claims 1 to 4,
**characterised in that** the first and the second current source (16, 17) is constructed as a resistor.

6. A circuit arrangement according to one of Claims 1 to 5,
**characterised in that** a diode device (30) is switched between the drain connection (D) and gate connection (G) of the power MOSFET (1).

7. A circuit arrangement according to Claim 6,
**characterised in that** the diode device (30) comprises the series circuit of a third Zener diode (31) and of a second diode (32),
**in that** the third Zener diode is switched by its cathode connection (K) to the terminal (2) for supply voltage (V_{D}) and the second diode (32) is switched by its cathode connection (K) to the gate connection (G) of the power MOSFET (1).

8. A circuit arrangement according to one of Claims 1 to 7,
**characterised in that** the controllable switches (16, 17) are designed as p-channel or n-channel MOSFETs.

9. A circuit arrangement according to one of Claims 1 to 8,
**characterised in that** a current-limiting arrangement (40) is provided to disconnect the power MOSFET (1) in the event of excess current.

## Revendications

1. Montage pour commander un MOSFET à enrichissement de puissance (1) relié à une charge (5) à la source tel que :
a) le drain (D) du MOSFET de puissance (1) est relié à une borne (2) pour appliquer une tension d'alimentation (V_{D}),
b) la porte (G) du MOSFET de puissance (1) est reliée par un dispositif redresseur (7) et un condensateur (6) à une première borne d'entrée de commande (9) pour appliquer un signal de tension alternée.
c) la capacité porte-source du MOSFET de puissance (1) peut se décharger par l'intermédiaire d'un second MOSFET (10),
d) la source (S) et le drain (D) du MOSFET de puissance (1) sont reliés par un montage en série formé d'une première résistance (13) et du chemin de charge d'un troisième MOSFET (11) à enrichissement et à canal de type opposé,
e) une première source de courant (19) est reliée par un premier commutateur commandé (17) et une seconde résistance (12) à la borne (2) de la tension d'alimentation (V_{D}),
f) le point de liaison entre le premier commutateur commandé (17) et la seconde résistance (12) est relié à la porte (G) du troisième MOSFET (11),
**caractérisé en ce que**
g) le second MOSFET (10) est un MOSFET à enrichissement à canal de même type que celui du MOSFET de puissance (1),
h) la grille (G) du second MOSFET (10) est reliée au point de liaison du troisième MOSFET (11) et de la première résistance (13),
i) une seconde source de courant (18) est reliée par un second commutateur commandé (16) et une troisième résistance (15) à la borne (2) de la tension d'alimentation (V_{D}).
j) une diode (20) est reliée par la cathode (K) au point de liaison entre la troisième résistance (15) et le second commutateur commandé (16) et à l'anode (A) de la source (S) du second MOSFET (10),
k) les deux commutateurs commandés (16, 17) sont ouverts pour enclencher le MOSFET de puissance (1), et sont fermés pour le couper.

2. Montage selon la revendication 1,
**caractérisé par**
une première diode Zener (22) branchée en parallèle sur une première résistance (13).

3. Montage selon les revendications 1 ou 2,
**caractérisé par**
une seconde diode Zener (21) branchée en parallèle sur la seconde résistance (12).

4. Montage selon l'une quelconque des revendications 1 à 3,
**caractérisé en ce que**
les deux commutateurs commandés (16, 17) sont ouverts et fermés en même temps.

5. Montage selon l'une quelconque des revendications 1 à 4,
**caractérisé en ce que**
la première et la seconde sources de courant (18, 19) sont des résistances.

6. Montage selon l'une quelconque des revendications 1 à 5,
**caractérisé par**
un dispositif à diodes (30) branché entre le drain (D) et la porte (G) du MOSFET de puissance (1).

7. Montage selon la revendication 6,
**caractérisé en ce que**
le dispositif à diodes (30) comprend un montage en série formé d'une troisième diode Zener (31) et d'une seconde diode (32), la troisième diode Zener est reliée par sa cathode (K) à la borne (2) de la tension d'alimentation (V_{D}) et la seconde diode (32) est reliée par sa cathode (K) à la porte (G) du MOSFET de puissance (1).

8. Montage selon l'une quelconque des revendications 1 à 7,
**caractérisé en ce que**
les commutateurs commandés (16, 17) sont réalisés par des MOSFETS à canal (p) ou (n).

9. Montage selon l'une quelconque des revendications 1 à 8,
**caractérisé par**
un dispositif de limitation de courant (40) pour couper le MOSFET de puissance (1) en cas de surintensité.
